(19) Europäisches Patentamt
European Patent Office
Office européen des brevets

(11) **EP 3 370 274 B1**

(12) **EUROPEAN PATENT SPECIFICATION**

(45) Date of publication and mention of the grant of the patent:
**12.10.2022 Bulletin 2022/41**

(21) Application number: **16860212.6**

(22) Date of filing: **26.10.2016**

(51) International Patent Classification (IPC):
**H01L 51/52** (2006.01)     **H01L 27/32** (2006.01)
**G02B 5/30** (2006.01)

(52) Cooperative Patent Classification (CPC):
**H01L 51/5203; H01L 51/5281;** H01L 27/32;
H01L 51/5284

(86) International application number:
**PCT/KR2016/012097**

(87) International publication number:
**WO 2017/074029 (04.05.2017 Gazette 2017/18)**

(54) **ORGANIC LIGHT EMITTING ELEMENT**

ORGANISCHES LICHTEMITTIERENDES ELEMENT

ÉLÉMENT ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.10.2015 KR 20150149503**

(43) Date of publication of application:
**05.09.2018 Bulletin 2018/36**

(73) Proprietor: **LG Chem, Ltd.**
**Yeongdeungpo-gu**
**Seoul 07336 (KR)**

(72) Inventors:
• **LEE, Ilha**
**Daejeon 34122 (KR)**
• **PARK, Pumsuk**
**Daejeon 34122 (KR)**
• **HWANG, Ji Young**
**Daejeon 34122 (KR)**
• **KIM, Ki-Hwan**
**Daejeon 34122 (KR)**
• **LEE, Seung Heon**
**Daejeon 34122 (KR)**
• **OH, Dong Hyun**
**Daejeon 34122 (KR)**
• **PARK, Chan Hyoung**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
EP-A1- 2 767 985     JP-A- 2000 021 860
KR-A- 20100 129 596     KR-A- 20110 066 760
KR-A- 20140 030 075     KR-B1- 100 834 820
US-A1- 2007 030 569     US-A1- 2007 170 841
US-A1- 2013 140 065     US-A1- 2016 056 311

# Description

[Technical Field]

This application claims priority to and the benefit of Korean Patent Application No. 10-2015-0149503, filed in the Korean Intellectual Property Office on October 27, 2015.

The present specification relates to an organic light emitting device.

[Background Art]

An organic light emitting phenomenon refers to a phenomenon of converting electrical energy to light energy using an organic material. That is, when an appropriate organic material layer is positioned between an anode and a cathode, and voltage is applied between two electrodes, holes are injected into the organic material layer from the anode and electrons are injected into the organic material layer from the cathode. Exciton is generated when the injected holes and electrons encounter, and light is generated when the exciton falls down to a bottom state.

A metal electrode having high reflectance used in an organic light emitting device provides a surface, which reflects internally generated light in a direction of a light transmissive substrate, thereby assisting in the improvement of brightness. However, the metal electrode reflects peripheral light incident to an element structure through the light transmissive substrate and a light transmissive electrode, thereby degrading contrast of light emission recognized with the eyes when an observer views the reflected light.

In order to offset the reflection of the external light of the metal electrode, a method of additionally introducing a polarizing plate to the light transmissive substrate may be used. However, in this case, light generated in an organic emission layer is also blocked, in order to exhibit higher efficiency, power is increased and used, so that the amount of power consumed of the organic light emitting device is increased and a life of the organic light emitting device is decreased.

Accordingly, it is necessary to solve the problem by decreasing light reflection of the metal electrode of the organic light emitting device.

Document US 2007/170841 A1 discloses an OLED with one of the electrodes comprising a metal oxide as antireflective coating (ARC). Documents US 2013/140065 A1, EP 2 767 985 A1, US 2007/030569 and US 2016/056311 A1 disclose the possibility of using in a display an ARC comprising AlON.

[Disclosure]

[Technical Problem]

The present specification provides an organic light emitting device, which is capable of decreasing reflection of external light.

[Technical Solution]

The invention is defined in the appended claims.

[Advantageous Effects]

The organic light emitting device according to the exemplary embodiment of the present specification may implement excellent contrast by controlling reflection of external light.

The organic light emitting device according to the exemplary embodiment of the present specification does not need to include a polarizing plate for blocking reflection of external light, thereby implementing excellent brightness with lower power.

[Description of Drawings]

FIG. 1 illustrates an example of a laminated structure of an organic light emitting device according to an exemplary embodiment of the present specification.
FIG. 2 illustrates an example of a laminated structure of an organic light emitting device according to an exemplary embodiment of the present specification.
FIG. 3 illustrates an example of a laminated structure of an organic light emitting device according to an exemplary embodiment of the present specification.
FIG. 4 illustrates an example of a laminated structure of an organic light emitting device according to an exemplary embodiment of the present specification.
FIG. 5 illustrates an energy relationship between respective layers according to Example 1.
FIG. 6 illustrates an energy relationship between respective layers according to Example 2.

100: Transparent electrode
200: Metal electrode
300: Organic material layer
400: Light reflection reducing layer
500: Metal layer
600: Substrate

[Mode for Invention]

In the present specification, when it is said that a specific member is positioned "on" the other member, this includes a case where another member is present between two members, as well as a case where the specific member is in contact with the other member.

In the specification, unless explicitly described to the contrary, when it is said that a specific part "comprises" a specific constituent element, this means that another constituent element may be further included, not that another constituent element is excluded.

An organic light emitting device is operable only when holes and electrons smoothly move between an anode, a cathode, and respective layers provided between the anode and the cathode. When an energy relationship of any one layer is not matched with an adjacent layer, the organic light emitting device may not be operated.

The present inventors completed the present invention as a result of the repeated conduction of research on a material and a position of a light reflection reducing layer, which prevents reflection of a metal electrode according to external light, and enables an organic light emitting device to be operable. Particularly, the present inventors found that when a light reflection reducing layer including an aluminum oxynitride is formed at a contact position with a metal electrode, it is possible to control reflection of external light by the metal electrode, and further, there is no problem in operating an organic light emitting device.

Hereinafter, the present specification will be described in more detail.

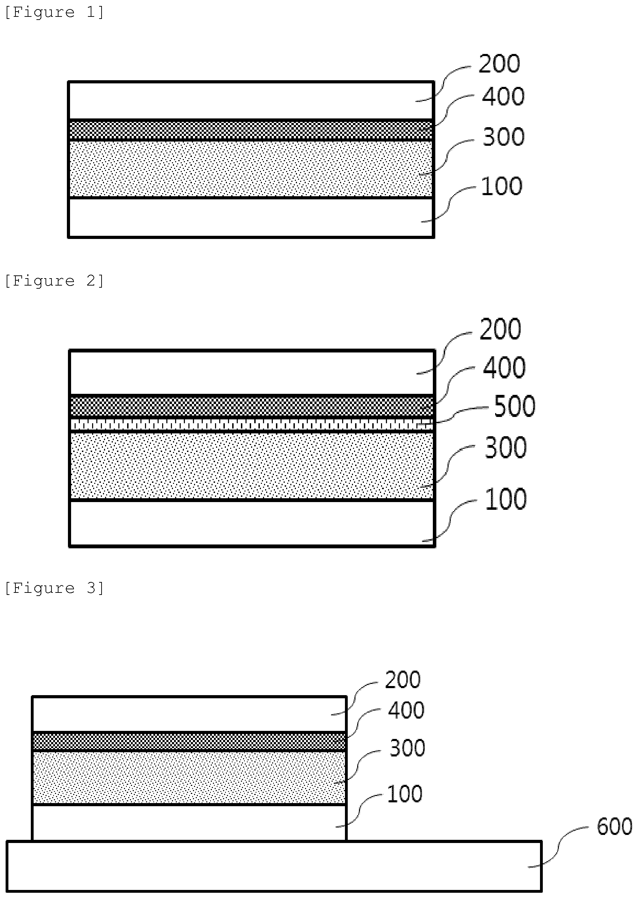

FIG. 1 illustrates an example of a laminated structure of an organic light emitting device according to an exemplary embodiment of the present specification. Particularly, FIG. 1 illustrates an organic light emitting device, in which a transparent electrode 100, an organic material layer 300, a light reflection reducing layer 400, and a metal electrode 200 are sequentially provided. However, the organic light emitting device according to the exemplary embodiment of the present specification is not limited to the structure of FIG. 1, and an additional layer may be further provided.

According to the present invention, the difference in work function between the metal electrode and the light reflection reducing layer is 0 eV or more and 1.4 eV or less.

When an electron transporting layer between the metal electrode and the organic material layer includes a material known in the art, an energy barrier of the metal electrode and the electron transporting layer is about 1.4 eV, so that a difference in a work function between the metal electrode and the light reflection reducing layer is 0 eV or more and 1.4 eV or less, and for example, a difference in a work function may be 0 eV or more and 0.5 eV or less, or 0 eV or more and 0.2 eV or less.

According to the present specification, when the difference in the work function between the metal electrode and the light reflection reducing layer is within the range, the organic light emitting device may be smoothly operated. In the organic light emitting device, an energy relationship between the respective layers is important, so that when the difference in the work function deviates from the range, there is a problem in that efficiency of the organic light emitting device is sharply degraded, or the organic light emitting device may not be operated.

According to the present invention, the work function of the light reflection reducing layer is 3.5 eV or more and 4.2 eV or less.

According to the present invention, the light reflection reducing layer includes an aluminum oxynitride expressed with $Al_xO_yN_z$ and x is at% of aluminum and has a value of 55 to 65, y is at% of oxygen and has a value of 1 to 10, and z is at% of nitrogen, and has a value of 30 to 40.

According to an exemplary embodiment of the present specification, the metal electrode may include one or two or more metals selected from the group consisting of Cu, Al, Mo, Ti, Ag, Ni, Mn, Au, Cr, and Co. Particularly, according to the exemplary embodiment of the present specification, the metal electrode may be a metal electrode including Al as a main material. More particularly, according to the exemplary embodiment of the present specification, the metal electrode may be formed of Al.

According to the present invention, the thickness of the light reflection reducing layer is 20 mm or more and 60 nm or less.

When the thickness of the light reflection reducing layer is within the range, it is possible to sufficiently control light reflectance of the metal electrode, and further it is possible to minimize an increase in a thickness of the organic light emitting device. The light reflection reducing layer may have a color in the achromatic series, but the color thereof is not particularly limited thereto. In this case, the color in the achromatic color series means a color that does not selectively absorb light incident to a surface of an object and appears when the light is evenly reflected and absorbed with respect to a wavelength of each component.

According to the exemplary embodiment of the present specification, the organic light emitting device may further include a second metal layer, which is in contact with a surface of the light reflection reducing layer facing the transparent electrode and has a thickness of less than 10 nm. Particularly, according to the exemplary embodiment of the present specification, a thickness of the metal layer may be 5 nm or less.

FIG. 2 illustrates an example of a laminated structure of an organic light emitting device according to an exemplary embodiment of the present specification. Particularly, FIG. 2 illustrates an organic light emitting device, in which a transparent electrode 100, an organic material layer 300, a metal layer 500, a light reflection reducing layer 400, and a metal electrode 200 are sequentially provided. However, the organic light emitting device according to the exemplary embodiment of the present specification is not limited to the structure of FIG. 2, and an additional layer may be further provided.

The metal layer is provided between the light reflection reducing layer and the adjacent layer to help electrons to more smoothly move.

According to the exemplary embodiment of the present specification, the metal layer may be transparent or translucent.

Further, the metal layer is formed of a thin film having a thickness of less than 10 nm, so that the metal layer is transparent or opaque, and according to an addition of the metal layer, light reflectance in the surface of the transparent electrode may be partially increased, but an electric characteristic of the organic light emitting device may be improved.

The term "transparent" in the present specification means that light reflectance in a visible ray region is 50% or more, 70% or more, or 80% or more.

Further, the term "translucent" in the present specification means that light reflectance in a visible ray region is 20 % or more, 30 % or more, or 40 % or more.

According to the exemplary embodiment of the present specification, an extinction coefficient k of the light reflection reducing layer may be 0.04 or more and 1.3 or less in light having a wavelength of 550 nm.

When the extinction coefficient is within the range, it is possible to effectively control light reflectance of the metal electrode, thereby further improving visibility of the organic light emitting device.

The extinction coefficient may be measured by using the Ellipsometer measurement equipment, which is known in the art.

The extinction coefficient k may also be called an absorption coefficient, and is an index defining how strong a target material absorbs light at a predetermined wavelength. Accordingly, the incident light passes through the light reflection reducing layer having the thickness t and is firstly absorbed according to the degree of extinction coefficient k, and the light reflected by the electrode layer in the lower portion of the light reflection reducing layer passes through the light reflection reducing layer having the thickness t again and is secondarily absorbed, and then is externally reflected. Accordingly, the thickness of the light reflection reducing layer and the value of the absorption coefficient act as the important factors influencing the entire reflectance.

According to the exemplary embodiment of the present specification, a refractive index n of the light reflection reducing layer may be 2 or more and 3 or less in light having a wavelength of 550 nm.

The first reflection occurs in a material of the light reflection reducing layer having the refractive index n together with the extinction coefficient k, and in this case, the main factors determining the first reflection are the refractive index n and the absorption coefficient k. Accordingly, the refractive index n and the absorption coefficient k are closely related to each other, and the effect may be maximized within the range.

According to the exemplary embodiment of the present specification, light reflectance in the surface of the transparent electrode may be 20 % or less in light having a wavelength of 550 nm.

According to the exemplary embodiment of the present specification, light reflectance in the surface of the light reflection reducing layer provided on the metal electrode may be 20% or less, 15% or less, or 10% or less in light having a wavelength of 550 nm.

Light reflectance of external light in the surface of the transparent electrode, from which light is extracted in the organic light emitting device, is considerably influenced by light reflectance of the surface of the metal electrode. The light reflection reducing layer is provided on the metal electrode and considerably decreases light reflectance of the surface of the metal electrode by external light, thereby enabling the organic light emitting device to implement clearer colors.

According to the exemplary embodiment of the present specification, the transparent electrode or the metal electrode may be provided on a substrate.

FIG. 3 illustrates an example of a laminated structure of an organic light emitting device according to an exemplary embodiment of the present specification. Particularly, FIG. 3 illustrates an organic light emitting device, in which a substrate 600, a transparent electrode 100, an organic material layer 300, a light reflection reducing layer 400, and a metal electrode 200 are sequentially provided. However, the organic light emitting device according to the exemplary embodiment of the present specification is not limited to the structure of FIG. 3, and an additional layer may be further provided.

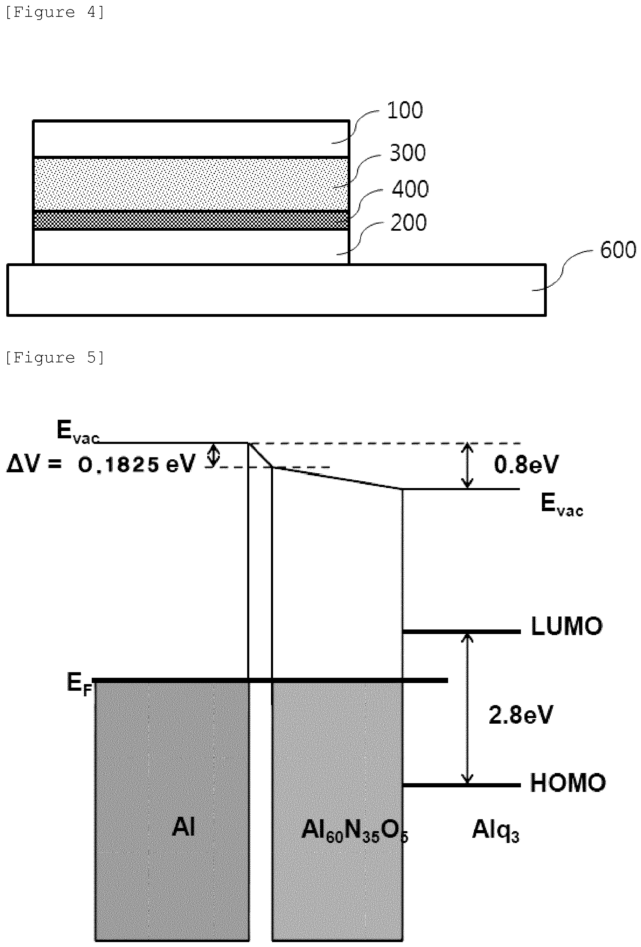

FIG. 4 illustrates an example of a laminated structure of an organic light emitting device according to an exemplary embodiment of the present specification. Particularly, FIG. 4 illustrates an organic light emitting device, in which a substrate 600, a metal electrode 200, a light reflection reducing layer 400, an organic material layer 300, and a transparent electrode 100 are sequentially provided. However, the organic light emitting device according to the exemplary embodiment of the present specification is not limited to the structure of FIG. 4, and an additional layer may be further provided. Further, in a case of the structure illustrated in FIG. 4, light generated in the organic material layer 300 is extracted through the transparent electrode 200, not the substrate 600, and the light reflection reducing layer 400 controls reflection of external light incident from the transparent electrode 100.

A substrate having excellent transparency, surface flatness, treatment easiness, and waterproofing property may be used as the substrate. Particularly, a glass substrate, a thin glass substrate, or a transparent plastic substrate may be used as the substrate. A film of polyethylene terephthalate (PET), polyethylene naphthalate (PEN), polyether ether ketone (PEEK), and polyimide (PI) may be included as the plastic substrate in a form of a single layer or a multilayer. Further, the substrate itself may include a light scattering function. However, the substrate is not limited thereto, and a substrate generally used in the organic light emitting device may be used.

According to the exemplary embodiment of the present specification, the transparent electrode includes: a metal, such as vanadium, chromium, copper, zinc and gold, or an alloy thereof; a metal oxide, such as zinc oxide, indium oxide, indium tin oxide (ITO), and indium zinc oxide (IZO); a combination of a metal and an oxide, such as ZnO:Al or SnO$_2$:Sb; a conductive polymer, such as poly(3-methylthiophene), poly[3,4-(ethylene-1,2-dioxy)thiophene] (PEDT), polypyrrole, and polyaniline; and the like, but is not limited thereto.

According to the exemplary embodiment of the present specification, the transparent electrode may be an anode and the metal electrode may be a cathode. Further, the transparent electrode may be a cathode, and the metal electrode may be an anode.

According to the exemplary embodiment of the present specification, the organic material layer may include one or more emission layers, and may further include one or two or more selected from the group consisting of a hole injection layer, a hole transporting layer, a hole blocking layer, a charge generating layer, an electron blocking layer, an electron transporting layer, and an electron injection layer.

The charge generating layer refers to a layer, in which holes and electrons are generated when a voltage is applied.

A material, which is capable of receiving holes from the anode or the hole injection layer and transferring the received holes to an emission layer, and has high mobility for holes, is suitable as a material of the hole transporting layer according to the present specification.

Detailed examples of the material of the hole transporting layer include an arylamine-based organic material, a conductive polymer, and a block copolymer in which a conjugate portion and a non-conjugate portion are simultaneously included, but are not limited thereto.

A material of the emission layer according to the present specification may be a material, which is capable of emitting light in a visible ray region by receiving holes and electrons from the hole transporting layer and the electron transporting layer, respectively, and combining the holes and the electrons, and has excellent quantum efficiency to fluorescent or phosphorescence. Particular examples of the material of the emission layer include 8-hydroxy-quinoline-aluminum complex (Alq$_3$), carbazole-based compounds, dimerized styryl compounds, BAlq; 10-hydroxybenzoquinoline-metal compounds, benzoxazole-based, benzthiazole-based and benzimidazole-based compounds, poly(p-phenylenevinylene)(PPV)-based polymers, spiro compounds, polyfluorene, rubrene, and the like, but the material of the emission layer is not limited thereto.

A material, which is capable of accepting and transferring electrons from the cathode to the emission layer, and has high mobility to electrons, is suitable as the material of the electron transporting layer according to the present specification. Particular examples of the material of the electron transporting layer include a 8-hydroxyquinoline Al complex; a complex including Alq$_3$; an organic radical compound; a hydroxyflavone metal complex, and the like, but are not limited thereto.

An exemplary embodiment of the present specification provides a display device including the organic light emitting device.

The organic light emitting device may serve as a back light in the display device. Further, the organic light emitting device may serve as an emission layer of a pixel unit in the display device. Configurations known in the art may be applied as the configurations necessary for the display device.

Hereinafter, the present specification will be described in detail with reference to the Examples. However, the Examples according to the present specification may be modified in various other forms, and the scope of the present specification is not interpreted as being limited to the Examples described in detail below. The Examples of the present specification are provided for more completely explaining the present specification to those skilled in the art.

In order to confirm whether the organic light emitting device according to the present specification is smoothly operated, the present inventors reviewed whether electrons move in the structure, in which the electron transporting layer, the light reflection reducing layer, and the metal electrode are sequentially laminated.

[Example 1]

In order to confirm whether electrons are movable in the organic light emitting device according to the present specification, an organic light emitting device, in which Alq is used as the electron transporting layer, Al$_{60}$N$_{35}$O$_5$ is used as the light reflection reducing layer, and Al is used as the metal electrode, was modelled. The modelling was performed through the ab initio density functional theory calculating method.

A work function W may be defined as described below.

$$W = -e\varnothing - EF$$

In the definition of the work function, -e means a charge quantity, and Ø means an electrostatic potential of vacuum in a peripheral area of a material surface. That is, a work function is minimum energy required for removing free electrons from a material.

A Fermi Level (EF) of Al$_{60}$N$_{35}$O$_5$ is 0.2025 eV, and when a work function is calculated through the definition of the work function by using the Fermi Level (EF) of Al$_{60}$N$_{35}$O$_5$, a work function of is Al$_{60}$N$_{35}$O$_5$ is 3.8975 eV.

FIG. 5 illustrates an energy relationship between respective layers according to Example 1.

Different materials have different Fermi levels, and also have different work functions. When two materials are away from each other, the two materials have unique values, but when two materials are close and bonded to each other, the Fermi levels of the heterogeneous materials are arranged by a movement of free electrons. Accordingly, a junction of a metal and a metal or a metal and a semiconductor has the same Fermi level. In this case, since a value of the work function is a unique value of the material, a contact potential, or a voltaic potential is generated by $\Delta V = ØA - ØB$ while the Fermi levels are arranged. According to the principle, the energy diagram of FIG. 5 is drawn, and a difference in a potential between the metal Al and $Al_{60}N_{35}O_5$ is small, so that a flow of the electrons between the two materials is not difficult.

According to FIG. 5, the work function of Al is known as 4.08 eV, and a difference in a work function between Al and $Al_{60}N_{35}O_5$ is 0.1825 eV, and an interlayer energy barrier is low, so that there is no problem in the movement of the charges. Further, it can be seen that there is no problem in the movement of the charges from to LUMO of Alq.

[Example 2]

In order to confirm whether charges move in the organic light emitting device according to the present specification, an organic light emitting device, in which Alq is used as the electron transporting layer, $Al_{58}N_{38}O_4$ is used as the light reflection reducing layer, and Al is used as the metal electrode, was modelled.

A Fermi Level (EF) of $Al_{58}N_{38}O_4$ is -0.1444 eV, and when a work function is calculated through the definition of the work function by using the Fermi Level (EF) of $Al_{60}N_{35}O_5$, a work function of is $Al_{58}N_{38}O_4$ is 4.0144 eV.

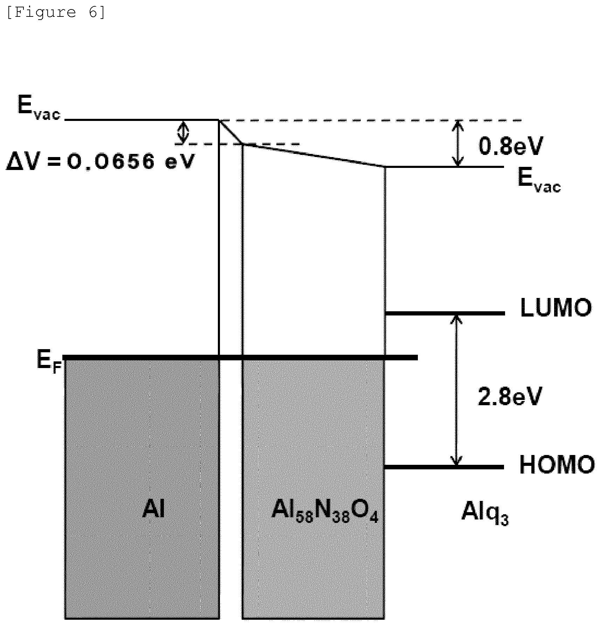

FIG. 6 illustrates an energy relationship between respective layers according to Example 2.

According to FIG. 6, the work function of Al is known as 4.08 eV, and a difference in a work function between Al and $Al_{58}N_{38}O_4$ is 0.0656 eV, and an interlayer energy barrier is low, so that there is no problem in the movement of the charges. Further, it can be seen that there is no problem in the movement of the charges from $Al_{58}N_{38}O_4$ to LUMO of Alq.

**Claims**

1. An organic light emitting device, comprising:

a transparent electrode (100);
a metal electrode (200) provided to face the transparent electrode (100);
one or more organic material layers (300) provided between the transparent electrode (100) and the metal electrode (200); and
a light reflection reducing layer (400) provided between the metal electrode (200) and the one or more organic material layers (300) and being in contact with the surface of the metal electrode (200) facing the transparent electrode (100),
wherein the organic material layer (300) includes one or more emission layers, the organic light emitting device being
**characterised in that**
the light reflection reducing layer (400) includes an aluminum oxynitride expressed with $Al_xO_yN_z$ wherein
x is at% of aluminum and has a value of 55 to 65,
y is at% of oxygen and has a value of 1 to 10, and
z is at% of nitrogen and has a value of 30 to 40,
the difference in the work function between the metal electrode (200) and the light reflection reducing layer (400) is 0 eV or more and 1.4 eV or less,
the work function of the light reflection reducing layer (400) is 3.5 eV or more and 4.2 eV or less, and
the thickness of the light reflection reducing layer (400) is 20 nm or more and 60 nm or less.

2. The organic light emitting device of claim 1, wherein the metal electrode (200) includes one or two or more metals selected from the group consisting of Cu, Al, Mo, Ti, Ag, Ni, Mn, Au, Cr, and Co.

3. The organic light emitting device of claim 1, further comprising:

a second metal layer (500), provided between the light reflection reducing layer (400) and the one or more organic material layers (300) and which is in contact with the surface of the light reflection reducing layer (400) facing the transparent electrode (100) and has a thickness of less than 10 nm,
wherein the second metal layer (500) is transparent or translucent.

4. The organic light emitting device of claim 1, wherein an extinction coefficient (k) of the light reflection reducing layer (400) is 0.04 or more and 1.3 or less in light of a wavelength of 550 nm.

5. The organic light emitting device of claim 1, wherein a refractive index (n) of the light reflection reducing layer (400) is 2 or more and 3 or less in light of a wavelength of 550 nm.

6. The organic light emitting device of claim 1, wherein the transparent electrode (100) or the metal electrode (200) is provided on a substrate (600).

7. A display device including the organic light emitting device according to any one of claims 1 to 6.

**Patentansprüche**

1. Organische lichtemittierende Vorrichtung, umfassend:

eine transparente Elektrode (100);

eine Metallelektrode (200), die bereitgestellt ist, um der transparenten Elektrode (100) gegenüberzuliegen;

eine oder mehrere organische Materialschichten (300), die zwischen der transparenten Elektrode (100) und der Metallelektrode (200) bereitgestellt ist bzw. sind;

eine Lichtreflektionsreduzierungsschicht (400), die zwischen der Metallelektrode (200) und der einen oder den mehreren organischen Materialschichten (300) bereitgestellt ist und mit der Oberfläche der Metallelektrode (200), die der transparenten Elektrode (100) gegenüberliegt, in Kontakt ist,

wobei die organische Materialschicht (300) eine oder mehrere Emissionsschichten einschließt, wobei die organische lichtemittierende Vorrichtung **dadurch gekennzeichnet ist, dass** die Lichtreflektionsreduzierungsschicht (400) ein Aluminiumoxynitrid einschließt, das als $Al_xO_yN_z$ ausgedrückt ist, wobei

x Atom% von Aluminium ist und einen Wert von 55 bis 65 aufweist,

y Atom% von Sauerstoff ist und einen Wert von 1 bis 10 aufweist, und

z Atom% von Stickstoff ist und einen Wert von 30 bis 40 aufweist,

wobei der Unterschied in der Arbeitsfunktion zwischen der Metallelektrode (200) und der Lichtreflektionsreduzierungsschicht (400) o eV oder mehr und 1,4 eV oder weniger ist,

die Arbeitsfunktion der Lichtreflektionsreduzierungsschicht (400) 3,5 eV oder mehr und 4,2 eV oder weniger ist, und

die Dicke der Lichtreflektionsreduzierungsschicht (400) 20 nm oder mehr und 60 nm oder weniger ist.

2. Organische lichtemittierende Vorrichtung nach Anspruch 1, wobei die Metallelektrode (200) ein oder zwei oder mehr Metalle einschließt, die ausgewählt sind aus der Gruppe bestehend aus Cu, Al, Mo, Ti, Ag, Ni, Mn, Au, Cr und Co.

3. Organische lichtemittierende Vorrichtung nach Anspruch 1, weiter umfassend:

eine zweite Metallschicht (500), die zwischen der Lichtreflektionsreduzierungsschicht (400) und der einen oder den mehreren organischen Materialschichten (300) bereitgestellt ist, und die in Kontakt ist mit der Oberfläche der Lichtreflektionsreduzierungsschicht (400), die der transparenten Elektrode (100) gegenüberliegt, und die eine Dicke von weniger als 10 nm aufweist,

wobei die zweite Metallschicht (500) transparent oder transluzent ist.

4. Organische lichtemittierende Vorrichtung nach Anspruch 1, wobei ein Extinktionskoeffizient (k) der Lichtreflektionsreduzierungsschicht (400) 0,04 oder mehr und 1,3 oder weniger bei Licht einer Wellenlänge von 550 nm ist.

5. Organische lichtemittierende Vorrichtung nach Anspruch 1, wobei ein Brechungsindex (n) der Lichtreflektionsreduzierungsschicht (400) 2 oder mehr und 3 oder weniger bei Licht einer Wellenlänge von 550 nm ist.

6. Organische lichtemittierende Vorrichtung nach Anspruch 1, wobei die transparente Elektrode (100) oder die Metallelektrode (200) auf einem Substrat (600) bereitgestellt ist.

7. Anzeigevorrichtung, die die organische lichtemittierende Vorrichtung nach einem der Ansprüche 1 bis 6 einschließt.

**Revendications**

1. Dispositif organique émetteur de lumière, comprenant :

une électrode transparente (100) ;

une électrode métallique (200) disposée de manière à faire face à l'électrode transparente (100) ;

une ou plusieurs couches d'un matériau organique (300) disposées entre l'électrode transparente (100) et l'électrode métallique (200) ; et

une couche réduisant la réflexion de la lumière (400) qui est disposée entre l'électrode métallique (200) et les une ou plusieurs couches d'un matériau organique (300) et qui est en contact avec la surface de l'électrode métallique (200) faisant face à l'électrode transparente (100),

où la couche d'un matériau organique (300) inclut une ou plusieurs couches émettrices, le dispositif organique émetteur de lumière étant **caractérisé en ce que**

la couche réduisant la réflexion de la lumière (400) inclut un oxynitrure d'aluminium exprimé par $Al_xO_yN_z$, où

x représente le % atomique d'aluminium et a une valeur qui va de 55 à 65,

y représente le % atomique d'oxygène et a une valeur qui va de 1 à 10,

z représente le % atomique d'azote et a une valeur qui va de 30 à 40,

la différence en termes de travail d'extraction entre l'électrode métallique (200) et la couche réduisant la réflexion de la lumière (400) est égale ou supérieure à o eV et inférieure ou égale à 1,4 eV,

le travail d'extraction de la couche réduisant la réflexion de la lumière (400) est égal ou supérieur à 3,5 eV et inférieur ou égal à 4,2 eV et l'épaisseur de la couche réduisant la réflexion de la lumière (400) est égale ou supérieure à 20 nm et inférieure ou égale à 60 nm.

2. Dispositif organique émetteur de lumière de la revendication 1, où l'électrode métallique (200) inclut un ou deux ou plusieurs métaux sélectionnés dans le groupe consistant en Cu, Al, Mo, Ti, Ag, Ni, Mn, Au, Cr et Co.

3. Dispositif organique émetteur de lumière de la revendication 1 comprenant en outre :

une deuxième couche métallique (500) qui est disposée entre la couche réduisant la réflexion de la lumière (400) et les une ou plusieurs couches d'un matériau organique (300), qui est en contact avec la surface de la couche réduisant la réflexion de la lumière (400) faisant face à l'électrode transparente (100) et qui a une épaisseur inférieure à 10 nm,

où la deuxième couche métallique (500) est transparente ou translucide.

4. Dispositif organique émetteur de lumière de la revendication 1, où un coefficient d'extinction (k) de la couche réduisant la réflexion de la lumière (400) est égal ou supérieur à 0,04 et inférieur ou égal à 1,3 pour une lumière d'une longueur d'onde de 550 nm.

5. Dispositif organique émetteur de lumière de la revendication 1, où un indice de réfraction (n) de la couche réduisant la réflexion de la lumière (400) est égal ou supérieur à 2 et inférieur ou égal à 3 pour une lumière d'une longueur d'onde de 550 nm.

6. Dispositif organique émetteur de lumière de la revendication 1, où l'électrode transparente (100) ou l'électrode métallique (200) est disposée sur un substrat (600).

7. Dispositif d'affichage incluant le dispositif organique émetteur de lumière selon l'une quelconque des revendications 1 à 6.

[Figure 1]

[Figure 2]

[Figure 3]

[Figure 4]

[Figure 5]

[Figure 6]

**EP 3 370 274 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020150149503
- US 2007170841 A1
- US 2013140065 A1
- EP 2767985 A1
- US 2007030569 A
- US 2016056311 A1